# EUROPÄISCHE PATENTSCHRIFT

(11) **EP 1 172 842 B1**
(45) Veröffentlichungstag und Bekanntmachung des Hinweises auf die Patenterteilung: **20.10.2004**
(21) Anmeldenummer: 01114426.8
(22) Anmeldetag: 15.06.2001
(51) Int. Cl.: H01L 21/00, C23C 14/56

(54) **Beschichtungsanlage für scheibenförmige Werkstücke**
Coating station for disk-type workpieces
Station de revêtement pour des pièces en forme de disque

(30) Priorität: 22.06.2000 CH 12332000
(43) Veröffentlichungstag der Anmeldung: 16.01.2002
(73) Patentinhaber: Unaxis Balzers Aktiengesellschaft, 9496 Balzers (LI)
(72) Erfinder: Matt, Thomas, 6811 Göfis (AT)
(74) Vertreter: Troesch Scheidegger Werner AG

(56) Entgegenhaltungen:
- DE-C- 19 806 282
- DE-U- 29 716 440

## Beschreibung

Die vorliegende Erfindung geht von der Aufgabe aus (1), bei Beschichtungsanlagen z.B. mit praktisch durchgehendem 24-Stunden-Produktionsbetrieb, Stillstandzeiten für den Unterhalt, wie z.B. für das Ersetzen beim Beschichtungsprozess verbrauchter Materialquellen bzw. anderer Anlageteile, wie von Beschichtungsmasken, zu reduzieren. Dabei soll (2) die Beschichtungsanlage konstruktiv möglichst einfach und kompakt sein.

Beschichtungsanlagen weisen üblicherweise eine Transportkammer auf, worin Werkstücke, im einfachsten Fall, von einer Ein-/Ausgabe-Schleusenstation zu einer Beschichtungsstation transportiert werden. Dort werden sie beschichtet, dann zur Ein-/Ausgabe-Schleusenstation rücktransportiert. Aus der Erfordernis (2) nach möglichst einfacher Konzeption wird an der Transportkammer, über eine Pumpenöffnung, eine Pumpeinheit vorgesehen, welche gleichzeitig für die Evakuierung der Behandlungsstation verantwortlich ist. Somit wird bei Anlagen dieser Art beim Fluten der Behandlungsstation auch die Transportkammer geflutet. Andernfalls müsste nämlich die Beschichtungsstation von der Transportkammer mit einer relativ aufwendigen Ventileinrichtung abschottbar sein.

Eine massgebliche Verlängerung der Produktionsstillstandzeiten bei Fluten von Beschichtungsstation und Transportkammer resultiert daraus, dass zusammen mit der Transportkammer mindestens Teile der an die Pumpöffnung angeflanschten Pumpeinheit geflutet werden. Dies führt zu relativ langen Rekonditionierungszeiten für die Betriebswiederaufnahme einerseits. Beispielsweise bei Vorsehen von Turbovakuumpumpen an der Pumpeinheit müssen andererseits letztere von der Flutung abgeschottet werden, was aufwendige Abschottungsventile erforderlich macht.

Die obgenannte Aufgabe (1), nämlich Minimalisierung von Stillstandzeiten gleichzeitig mit Schaffung (2) einer möglichst einfachen Anlagekonfiguration mit hoher Produktionsrate, wird durch eine Anlage nach dem Wortlaut von Anspruch 1 realisiert.

Die erfindungsgemässe Beschichtungsanlage weist mithin eine Transportkammer auf mit einer Werkstücktransportanordnung. Letztere hat mindestens zwei mit einer gesteuert getriebenen Drehachse verbundene, gesteuert getrieben linear ausfahrbare und rückholbare Transportstössel. Die Transportstössel liegen dabei in Mantellinie ein und desselben Rotationskörpers um die Drehachse und sind, bezüglich einer vorgegebenen Richtung auf der Drehachse, gleichsinnig ausfahrbar bzw. rückholbar. Endständig trägt jeder Stössel eine Werkstückaufnahme. An der Transportkammer sind weiter mindestens zwei Bedienungsöffnungen vorgesehen, über welche die Transportkammer mit Stationen kommuniziert, wovon eine eine Beschichtungsstation ist. Die Flächennormalen der lichten Flächen der erwähnten Bedienungsöffnungen sind dabei in Richtung von Mantellinien des Rotationskörpers gerichtet.

Es ist weiter an der erfindungsgemässen Beschichtungsanlage eine mit der Transportkammer über eine Pumpöffnung kommunizierende Pumpeinheit vorgesehen, welche sowohl für die Transportkammer wie auch für die Beschichtungsstation wirksam ist.

Mindestens einer der erwähnten Stössel hat endständig eine Schliessanordnung oder ist damit ausrüstbar. Um das einfache Anlagekonzept, welches, in allen Ausführungsformen der erfindungsgemässen Beschichtungsanlage, äusserst hohe Produktionsraten erlaubt, auch bezüglich notwendiger Produktionsunterbrüche mit Flutung zu optimieren, dabei unter Beibehalt der einfachen Konstruktionskonzeption, ist die Pumpöffnung so an der Kammer angeordnet, dass der erwähnte Stössel auf die Pumpöffnung ausrichtbar ist, wobei die Schliessanordnung, bei Ausrichtung des erwähnten Stössels auf die Pumpöffnung und danach dessen Ausfahren, mit der Pumpöffnung in dichtend schliessende Wirkverbindung tritt.

Bezüglich des grundsätzlichen Aufbaus von Transportkammer mit den erwähnten Stösseln wird insbesondere auf die EP 0 518 109 entsprechend des US 5 245 736 und auf das DE-GM 29 716 440 (Basis für den Obergriff der Ansprüche 1 und 14) entsprechend der US-Anmeldung Nr. 08/964 962 hingewiesen.

In einer ersten Ausführungsform der erfindungsgemässen Beschichtungsanlage ist der Rotationskörper ein Zylinder oder ein Kegel mit einem Öffnungswinkel < 90°, und es sind, entsprechend, die erwähnten Stössel parallel oder schiefwinklig zur Drehachse linear getrieben ausfahrbar und rückholbar.

In einer bevorzugten Ausführungsform ist aber der Rotationskörper ein Spezialfall eines Kegels, nämlich mit 90°-Öffnungswinkel ϕ, und es ragen die Stössel radial von der Drehachse aus. Die Bedienungsöffnungen und die Pumpöffnung weisen dabei Flächennormalen auf, die in der Drehebene der Stössel um die Drehachse liegen.

Mithin hat in der letzterwähnten, bevorzugten Ausführungsform die Werkstücktransportanordnung mindestens zwei radial von einer gesteuert getriebenen Drehachse ausragende, gesteuert getrieben linear ausfahrbare und rückholbare Transportstössel, welche mithin in einer Ebene senkrecht zur Drehachse liegen. Wiederum sind endständig an jedem der Stössel entsprechende Werkstückaufnahmen vorgesehen. Im weiteren sind weiterhin mindestens zwei nun mit den Flächennormalen der lichten Öffnungen in der genannten Ebene angeordnete Bedienungsöffnungen an der Transportkammer vorgesehen, über die letztere mit Stationen kommuniziert, wovon weiterhin eine eine Werkstückbeschichtungsstation ist. Wie bei allen Ausführungsformen der erfindungsgemässen Beschichtungsanlage ist auch hier eine Pumpeinheit vorgesehen, welche, wirksam sowohl für die Transportkammer wie auch für die Beschichtungsstation, über eine Pumpenöffnung mit der Transportkammer kommuniziert.

Die Pumpöffnung ist an der Transportkammer wie erwähnt so angeordnet, dass mindestens einer der erwähnten Stössel, vorzugsweise jeder, auf sie ausrichtbar ist. Es weist dabei mindestens einer der erwähnten Stössel die Schliessanordnung auf oder ist damit bestückbar, so dass er bei Ausrichtung auf die Pumpöffnung durch Ausfahren mit der Pumpöffnung auch hier in dichtend schliessende Wirkverbindung treten kann.

Sind, wie bei der bevorzugten Ausführungsform der erfindungsgemässen Beschichtungsanlage und bezüglich der Drehachse die Stössel radial gerichtet, so liegt mithin auch die Flächennormale der lichten Fläche der Pumpöffnung in der Drehebene der erwähnten Stössel.

Wohl ist es aus der DE 19 742 923 grundsätzlich bekannt, für das Fluten einer Transportkammer die Pumpöffnung zu einer Pumpeinheit zu verschliessen. Die an der daraus vorbekannten Anlage vorgesehene Transportkammer weist aber als Werkstücktransportanordnung eine um eine Drehachse getriebene massive Trägerplatte auf, auf deren einen Plattenseite, bezüglich der Drehachse peripher, die Werkstücke positioniert sind. Durch axiales Anheben bzw. Absenken der Trägerplatte werden alle Werkstücke gleichzeitig, bei entsprechender Drehwinkelausrichtung, zu den auf der entsprechenden Stirnseite der Transportkammerwandung angeflanschten Stationen hin- bzw. von diesen rückbewegt. Die der Transportfläche der Trägerplatte gegenüberliegende Plattenfläche wirkt, im Flutungsfalle der Transportkammer, verschliessend auf eine Pumpöffnung. Diese Pumpöffnung ist auf der der Stirnseite mit den Stationen gegenüberliegenden Stirnseite der Transportkammer angebracht. Diese Anlage erfüllt keine der an die erfindungsgemässe Anlage gestellten aufgabengemässen Forderungen. So ist beispielsweise erkenntlich:
- Der Hubmechanismus für die Transportplatte muss so ausgelegt werden, dass er nicht nur, in Produktion, die Stationen mit Werkstücken bedienen kann, sondern auch für den wesentlich selteneren Fall zum Verschliessen der Pumpöffnung rückgeholt werden kann: Die ganze Anlage muss eigens für diesen "seltenen" Fall konzipiert sein.
   Da dieser zusätzliche Hub nur in Grenzen minimalisiert werden kann, nämlich soweit als durch die Transportplatte in Produktionsposition die Pumpenwirkung nicht gedrosselt werden soll, führt dies zu einer baulichen Vergrösserung und Verkomplizierung der Gesamtanlage.
- Es müssen relativ aufwendige Massnahmen getroffen werden, die durch die Bearbeitung lokal hitzebelastete Trägerplatte so auszubilden, dass sie jederzeit und Drehpositions-unabhängig das dichte Verschliessen der Pumpöffnung bewerkstelligen kann.
- Die mitunter aus dem erwähnten Grunde mit relativ hoher Masse zu realisierende Transportplatte steht einer hohen Produktionsrate insofern entgegen, als dass beim inkrementellen Drehen dieser Platte hohe Trägheitsmomente zu überwinden sind, was für hohe Produktionsraten entsprechend aufwendige Antriebe erfordert.

In einer weitaus bevorzugten Ausführungsform der erfindungsgemässen Beschichtungsanlage sind lediglich zwei der Stössel vorgesehen, welche in der genannten Ebene um 180° bezüglich der Drehachse winkelversetzt angeordnet sind.

Ist dabei der Rotationskörper ein Zylinder oder ein Kegel mit einem Öffnungswinkel, der kleiner ist als 90°, dann sind die erwähnten lediglich zwei Stössel in einer Ebene angeordnet, welche die erwähnte Drehachse enthält. Im Falle der bevorzugten Ausführungsform, bei der der Rotationskörper zu einem Kegel mit Öffnungswinkel 90° entartet ist, liegen die erwähnten vorgesehenen zwei Stössel sich bezüglich der Drehachse und in Aufsicht auf die Drehachse gegenüber, um 180° versetzt, somit auch in der erwähnten, die Drehachse enthaltenden Ebene.

Jedenfalls werden durch die Zwei-Stössel-Ausführungsform optimal tiefe mit der Transportanordnung zu bewegende Massen realisiert, wobei sich gezeigt hat, dass die Minimalisierung dieser Massen, mit Blick auf das Beschleunigungsverhalten eines für die Transportanordnung vorgesehenen Drehschrittantriebes, wesentlich wirkungsvoller ist als eine Konzeption mit mehr als zwei Stösseln und entsprechender Erhöhung der Anzahl vorgesehener Beschichtungsstationen. Durch diese bevorzugte Ausführungsform wird mithin, gleichzeitig mit massgeblicher Vereinfachung der Anlage im Sinne der Erfindungsaufgabe (2), eine Optimierung der Produktivität erreicht. Dies durch die Möglichkeit, den Transport zwischen den vorgesehenen Stationen durch schnelle 180°-Drehwinkelschritte zu realisieren.

Dabei werden in weitaus bevorzugter Art und Weise auch lediglich zwei der Stationen vorgesehen, wovon die eine eine Schleusenstation ist und die beiden Bedienungsöffnungen - zur Schleusenstation und zur Beschichtungsstation - bezüglich der Drehachse der Werkstücktransportanordnung um 180° winkelversetzt sind.

Ist dabei, wie in der einen der bevorzugten Ausführungsformen der erfindungsgemässen Anlage, der Rotationskörper ein Zylinder oder ein Kegel mit einem Öffnungswinkel, der kleiner ist als 90°, so sind die erwähnten Bedienungsöffnungen so angeordnet, dass die Flächennormalen ihrer lichten Öffnungen mit Mantellinien der erwähnten Rotationskörper fluchten, und zwar mit Mantellinien, welche sich bezüglich der Drehachse um 180° versetzt gegenüber liegen, d.h. welche in einer Ebene liegen, die die Drehachse enthält.

Bei der besonders bevorzugten Ausführungsform der erfindungsgemässen Anlage, bei der der Rotationskörper zu einem Kegel mit Öffnungswinkel 90° degeneriert ist, liegen sich die erwähnten Bedienungsöffnungen, in Richtung der Drehachse betrachtet und ihr bezüglich gegenüber, mit radial gerichteten Flächennormalen.

In bevorzugter Weiterausbildung der letzterwähnten Ausführungsform wird die Pumpöffnung zwischen den Bedienungsöffnungen und diesbezüglich vorzugsweise um 90° versetzt angeordnet.

Somit ist in der einen bevorzugten Ausführungsform der erfindungsgemässen Anlage, bei der der Rotationskörper ein Zylinder oder ein Kegel mit Öffnungswinkel ist, der kleiner ist als 90°, die Pumpöffnung wiederum so angeordnet, dass ihre Flächennormale mit Mantellinien des entsprechenden Rotationskörpers fluchtet, ist dabei bevorzugt und in Richtung der Drehachse betrachtet um 90° bezüglich der Bedienungsöffnungen versetzt, dazwischen angeordnet.

Bei der besonders bevorzugten Ausführungsform trifft letzteres genau gleich zu: in Aufsicht auf die Drehachse erscheinen die nun radial gerichteten Flächennormalen der Bedienungsöffnungen sich 180° winkelversetzt gegenüber liegend mit der diesbezüglich um 90° versetzten, dazwischen liegenden Pumpenöffnung.

Damit wird einerseits erreicht, dass im Produktionsbetrieb die Pumpwirkung durch die Werkstücktransportanordnung nicht beeinträchtigt wird. Anderseits kann für den Flutungsfall allein durch entsprechende Ansteuerung des Drehantriebes für die Werkstücktransportanordnung ein 90°- (anstelle von 180°) Drehwinkelschritt eingeleitet werden, um einen der vorgesehenen Stössel in Ausrichtung auf die Pumpöffnung zu bringen. Durch das - ohnehin auch für die Produktion vorgesehene - Ein- und Ausfahren der Stössel wird die Pumpöffnung verschlossen bzw. wieder freigegeben. Dies erfordert mithin keinen zusätzlichen Aufwand, denn der betrachtete Stössel führt diesen erwähnten pumpöffnungsbezogenen Hub auch während der Produktion bezüglich der Bedienungsöffnungen aus.

Dabei wird weiter bevorzugt, der Pumpöffnung bezüglich der Drehachse gegenüberliegend - so dass in der Ebene jeweils vorzugsweise um 90° versetzte vier Öffnungen vorgesehen sind - eine Zusatzöffnung in der Wand der Transportkammer angebracht. Diese Zusatzöffnung kann für eine Vielzahl unterschiedlicher Zwecke eingesetzt werden. Sie kann dabei z.B. zusammen mit der Verschliessung der Pumpenöffnung erforderlichenfalls auch verschlossen werden, kann bei Nichtverwendung mit einem Deckel verschlossen werden und beispielsweise für Servicearbeiten jeglicher Art und/oder zum Ausmessen von Werkstückparametern, wie beispielsweise zum Messen von Beschichtungsverteilungen und/oder Beschichtungsdicken etc., eingesetzt werden.

Im Sinne der möglichst einfachen Anlagekonzeption (2) wird weiter bevorzugt vorgeschlagen, dass die Innenräume der Beschichtungsstation und der Transportkammer über eine ungesteuerte Kommunikationsverbindung verbunden sind, d.h. ohne dass in eine solche Verbindung eine steuerbare Ventilanordnung vorgesehen wäre. Es handelt sich mithin bei einer solchen Verbindung, wie noch zu erläutern sein wird, um eine ungesteuerte Bypass-Verbindung.

In einer weiteren, weitaus bevorzugten Ausführungsform der erfindungsgemässen Anlage handelt es sich bei der vorgesehenen Beschichtungsstation um eine Sputterstation.

Obwohl die je endständig an den Stösseln der erfindungsgemässen Beschichtungsanlage vorgesehene Schliessanordnung auch durch daran positionierte scheibenförmige Werkstücke selber gebildet sein kann oder durch andere, eigens dafür vorgesehene Organe, ergibt sich eine weiter vereinfachte Konzeption dadurch, dass die Werkstückaufnahmen durch Werkstückaufnahmeteller gebildet sind, jeweils für mindestens ein scheibenförmiges Werkstück, und dabei dieser Teller die Schliessanordnung bildet. Grundsätzlich kann an den vorgesehenen Werkstückaufnahmen stösselachsenzentriert jeweils ein scheibenförmiges, weitaus bevorzugt kreisscheibenförmiges, Werkstück applizierbar sein, oder, um die erwähnte Stösselachse herum gruppiert, zwei oder mehr scheibenförmige Werkstücke, wiederum klar bevorzugt kreisscheibenförmige.

Obwohl es weiter durchaus möglich ist, an der erfindungsgemässen Beschichtungsanlage nur einen oder nur einen Teil der vorgesehenen Stössel mit der geforderten Schliessanordnung zu versehen - den jeweiligen Stössel im Flutungsfall auf die Pumpöffnung auszurichten - wird in einer weitaus bevorzugten Ausführungsform an allen Stösseln die erwähnte Schliessanordnung vorgesehen und diese wie erwähnt bevorzugt auch als Werkstückträgerteller ausgebildet. Damit ist aber gleichzeitig die Möglichkeit gegeben, auch die Bedienungsöffnungen im Produktionsbetrieb - wie im Flutungsbetrieb die Pumpöffnung - zu schliessen. Bei vorgesehener Schleusenstation wirkt dann die erwähnte Schliessanordnung am auf die Schleusenstation ausgerichteten Stössel direkt als Schleusenventil, und/oder es trennt an der Beschichtungsstation die erwähnte Schliessanordnung des entsprechend auf diese Station ausgerichteten Stössels den Beschichtungsprozess von der Transportkammer ab.

Die erfindungsgemässe Anlage, insbesondere in ihrer bevorzugten Zwei-Stössel/Zwei-Stationen-Konfiguration, eignet sich insbesondere für die Fertigung magnetischer oder optischer Speicherscheiben, bevorzugt optischer Speicherscheiben, dabei insbesondere für die Fertigung von CDs aller Art, seien dies normale, werkseitig bespielte CDs, CDR oder CDRW.

Die Erfindung wird anschliessend beispielsweise anhand von Figuren erläutert. Diese zeigen:
- Fig. 1: schematisch und vereinfacht, eine teilweise geschnittene Aufsichtsdarstellung auf eine erfindungsgemässe Beschichtungsanlage in der besonders bevorzugten Ausführungsform;
- Fig. 2: in Darstellung analog zu Fig. 1, eine weitere teilweise geschnittene Darstellung in einer bezüglich der Darstellung von Fig. 1 um 90° geschwenkten Betrachtungsrichtung;
- Fig. 3: schematisch eine erfindungsgemässe Beschichtungsanlage in einer weiteren bevorzugten Ausführungsform, nämlich mit zylinderförmigem, durch die Stösseldrehbewegung definiertem Rotationskörper, und
- Fig. 4: in einer Darstellung analog zu Fig. 3, eine erfindungsgemässe Beschichtungsanlage mit kegelförmigem, durch die Stösselbewegung definiertem Rotationskörper, mit einem Kegelöffnungswinkel < 90°.

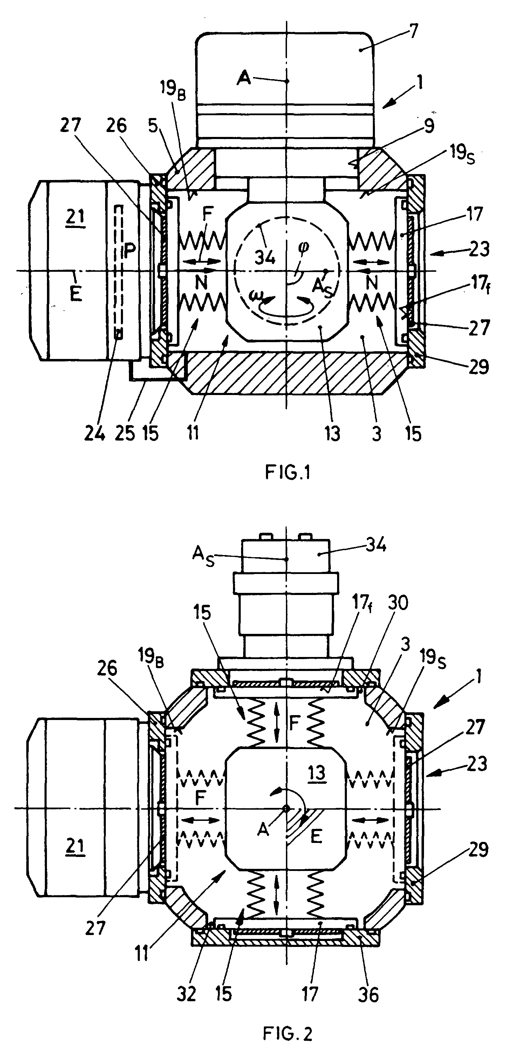

In den Figuren 1 und 2 ist die besonders bevorzugte erfindungsgemässe Beschichtungsanlage dargestellt, höchst kompakt und konzeptionell einfach, was zu äusserst kurzen Fertigungstakten führt.

Die erfindungsgemässe Beschichtungsanlage 1 weist eine Transportkammer 3 auf. Sie ist im wesentlichen rotationssymmetrisch zu einer Achse A aufgebaut. An einer Wandungspartie 5 der Transportkammer 3, zur Achse A im wesentlichen senkrecht, ist ein gesteuerter Transportantrieb 7 angeflanscht, bevorzugterweise ein Schrittantrieb. Über eine Öffnung 9 in der erwähnten Wandung 5 treibt er eine in der Transportkammer 3 vorgesehene Transportanordnung 11 an. An einem in die Transportkammer 3 einragenden Achsstummel 13 des Antriebes 7 sind bezüglich der Achse A und damit der Antriebsdrehachse zwei sich gegenüberliegend Stössel 15 montiert. Sie liegen bezüglich der Achse A radial ausspringend in einer Ebene E, die senkrecht zur Achse A ist. Bei ihrer Drehbewegung ω um die Drehachse A definieren die Stössel 15 einen entarteten Kegel mit Kegelöffnungswinkel ϕ = 90°. Die Stössel 15 weisen bevorzugterweise und wie dargestellt balggekapselte Linearantriebe auf, mittels welchen jeder der Stössel unabhängig vom andern, wie mit den Doppelpfeilen F angedeutet, und bezüglich der Achse A radial ausgefahren bzw. rückgeholt werden kann. Wenn wir bezüglich der Linearantriebe für die Stössel 15 von unabhängigen Antrieben sprechen, so heisst dies, dass sie in beliebiger Abhängigkeit voneinander ansteuerbar sind, also auch z.B. und bevorzugt synchron.

Endständig tragen die Stössel 15 je Werkstückaufnahmeteller 17, deren Tellerflächen 17f senkrecht zu den Stösselachsen A_{S} liegt.

In der Wandung der Transportkammer 3 sind zwei Bedienungsöffnungen angebracht. An der einen, 19_{B}, ist eine Sputterstation 21 angeflanscht. An der andern, 19_{S}, ist eine Schleusenstation 23 realisiert.

Die beiden Öffnungen 19_{B} und 19_{S} liegen sich mit ihren zentralen Öffnungsflächen-Normalen N an der Transportkammer 3 gegenüber, sind also, wie sich ohne weiteres aus Fig. 2 ergibt, bezüglich der Achse A um 180° drehwinkelversetzt und liegen mit der zentralen Normalen N, die gemäss Fig. 1 in die Achse A_{S} fällt, auch in der Ebene E. Somit können die beiden Öffnungen 19_{B} und 19_{S} jeweils gleichzeitig durch die Stössel 15 bedient werden und damit die jeweils vorgesehenen Stationen 21 und 23, wie sich aus der gestrichelten Stösselposition von Fig. 2 ohne weiteres ergibt.

In Fig. 1 ist gestrichelt an der Sputterstation 21 schematisch ein Target 24 dargestellt. Es verbindet eine Verbindungsleitung 25 den Sputterkammerprozessraum P mit dem Innern der Transportkammer 3. Selbstverständlich wird die in Fig. 1 aus Übersichtsgründen schematisch dargestellte Verbindungsleitung 25 z.B. in den Flansch 26 für die Montage der Sputterstation 21 und/oder in die Wandung der Transportkammer 3 integriert, was insbesondere deshalb ohne weiteres möglich ist, weil die erwähnte Bypass-Verbindung nicht ventilgesteuert ist. Über diese Leitung 25 kommunizieren Innenraum der Transportkammer 3 und Prozessraum der Sputterstation 21 permanent und bilden wenn erwünscht gezielt eine Druckstufe.

Wie weiter ersichtlich, wirkt der Werkstückaufnahmeteller 17 an dem jeweils auf die Schleusenstation 23 ausgerichteten Stössel 15 als Transportkammer-zugewandtes Schleusenventil. Die im wesentlichen innerhalb der Wandungsstärke der Transportkammer 3 realisierte Schleusenstation 23 für kreisscheibenförmige Werkstücke, insbesondere magnetische oder optische Speicherscheiben, dabei insbesondere optische Speicherscheiben, bevorzugt CD's aller Art, wie CDR's oder CDRW's, 27, wird (nicht dargestellt) über einen separaten Pumpanschluss in den minimalisierten Schleusenraum evakuiert.

Atmosphärenseitig wird der Schleusenraum der Schleusenstation 23 durch ein aussenliegendes, schematisch dargestelltes Schleusenventil 29 verschlossen.

Analog sperrt der Werkstückaufnahmeteller 17 am entsprechend ausgerichteten Stössel 15 den Prozessraum P der Sputterstation 21 bezüglich dem Innenraum der Transportkammer 3 ab, wodurch die Transportkammer von der Prozesskammer abgeschirmt wird.

Wie nun weiter aus den Figuren ersichtlich, ist in der Ebene E und (siehe insbesondere Fig. 2) bezüglich der Bedienungsöffnungen 19_{S} und 19_{B} jeweils um 90° versetzt an der Wandung der Transportkammer 3 eine Pumpenöffnung 30 vorgesehen und, in bevorzugter Ausführungsform der Pumpenöffnung 30 bezüglich der Achse A gegenüberliegend und weiterhin in Ebene E, eine weitere Öffnung 32, die als "Serviceöffnung" bezeichnet sei.

An der Pumpöffnung 30 ist eine Pumpeneinheit 34 (in Fig. 1 gestrichelt angedeutet) montiert, bevorzugterweise eine mechanische Molekularpumpe, wie insbesondere eine Turbovakuumpumpe, z.B. eine Turbomolekularpumpe und/oder Turbomolekular-Drag-Pumpe, umfassend. Wird die Serviceöffnung 32 nicht oder erst nach Fluten der Anlage gebraucht, so wird sie, wie in Fig. 2 dargestellt, mittels eines Deckels bzw. Blindflansches 36 verschlossen. Durch diese Öffnung hindurch können Servicearbeiten vorgenommen werden oder es können an dieser Öffnung 32 manuell Messungen vorgenommen werden und/oder Messwertfühler etc. eingebaut werden (nicht dargestellt).

Wie sich insbesondere aus Fig. 2 ergibt, können nun eine oder beide der Öffnungen 30 bzw. 32 dadurch verschlossen werden, dass die Stössel 15 nicht wie während der Produktion jeweils um 180°-Drehwinkelschritte zwischen den Bedienungsöffnungen 19_{B} und 19ₛ hin und her geschwenkt werden, sondern in eine Zwischenposition, bezüglich der erwähnten "Betriebspositionen" um 90° versetzt. Muss, aus welchen Gründen auch immer, aber insbesondere zum Target-Wechsel oder Beschichtungsmasken-Wechsel, die Sputterstation 21 als Beschichtungsstation und damit, aufgrund der Verbindung 25, auch die Transportkammer 3 geflutet werden, so wird der eine der Stössel 15 in die in Fig. 2 ausgezogen dargestellte Zwischendrehposition geschwenkt und insbesondere die Pumpöffnung 30 durch Einsatz des Werkstückaufnahmetellers 17 als Schliessanordnung verschlossen. Dabei kann erforderlichenfalls, und wie in Fig. 2 ebenfalls dargestellt, mit dem zweiten Stössel 15 auch die Serviceöffnung 32 verschlossen werden.

Dadurch wird mit einer optimal einfachen und kompakten Anlage die ohnehin für den Produktionsbetrieb eingesetzte, höchst kompakte und einfache Transportanordnung mit den Stösseln 15 auch dafür eingesetzt, im Flutungsfalle die Pumpeneinheit 34 abzuschotten.

Mit einer derartigen erfindungsgemässen Beschichtungsanlage wird eine Produktionstaktrate von beispielsweise 2,5 Sek. erreicht. Das heisst alle 2,0 Sek. wird ein beschichtete Werkstückscheibe ausgeschleust. Beispielsweise muss dabei an der Sputterstation 21 nach einer Produktionsbeschichtung von 50'000 Werkstückscheiben ein Targetwechsel und nach einer Produktionsbeschichtung von beispielsweise 5'000 Werkstückscheiben ein Maskenwechsel vorgenommen werden. Daraus folgt eine notwendig werdende Anlagenflutung ca. jeweils nach drei Stunden für Maskenwechsel, nach jeweils 28 Betriebsstunden zum Targetwechsel. Die notwendige Zeitspanne, um eine Pumpeinheit mit Turbovakuumpumpe jeweils wieder hochzufahren, dauert mindestens drei Minuten. Obwohl diese Zeitspanne kurz erscheint, ergibt sich aber, dass bei einem dreiminütigen zusätzlichen Betriebsunterbruch einer Anlage ohne Pumpenanschottung im Flutungsfall eine rund zweiprozentige Produktivitätsminderung resultiert, was bei den oben aufgeführten Zahlen einer Produktitivitätseinbusse von ca. 250'000 Werkstücken pro Jahr entspricht. Hinzu kommt - was besonders wichtig ist - die Verkürzung der Lebensdauer der empfindlichen mechanischen Molekularpumpe. An der erfindungsgemässen Anlage fällt die erwähnte zusätzliche Betriebsunterbruchs-Zeitspanne weg und die Pumpe erreicht die bestmögliche Lebensdauer, da sie nicht immer wider herunter und wieder hochgefahren werden muss.

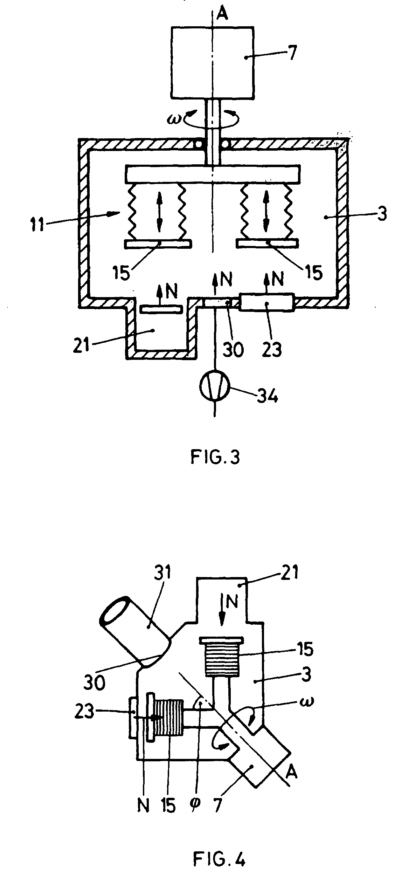

In Fig. 3 ist schematisch eine weitere Ausführungsform der erfindungsgemässen Beschichtungsanlage dargestellt. Ihr Aufbau versteht der Fachmann ohne weiteres aus den bisherigen Erläuterungen. Es sind für funktionell gleiche Teile dieselben Bezugszeichen verwendet, wie sie bereits im Zusammenhang mit den Erläuterungen zu den Fig. 1 und 2 verwendet wurden.

Die zwei Stössel 15 sind hier im Unterschied zur besonders bevorzugten Ausführungsform gemäss den Fig. 1 und 2 parallel zur Drehachse A angeordnet. Sie spannen mithin, bei ihrer Drehbewegung ω um die Achse A, einen Zylinder auf. Bevorzugterweise sind wiederum zwei sich bezüglich der Achse A um 180° gegenüberliegende Stössel vorgesehen, welche auf die schematisiert dargestellten Stationen 21 und 23 wirken. Die Zentrumsöffnungsnormalen N der lichten Flächen der die Transportkammer 3 mit den Stationen 21 bzw. 23 verbindenden Öffnungen sind auf die Mantellinien des durch die Stösseldrehbewegung aufgespannten Zylinders ausgerichtet. Die Pumpöffnung 30 für Pumpeinheit 34 und die gegebenenfalls vorgesehene (nicht dargestellte) Serviceöffnung 32 sind, mit ebenso ausgerichteten Flächennormalen N, bezüglich den Bedienungsöffnungen zu den Stationen 21 bzw. 23 um 90° versetzt angeordnet.

Gemäss Fig. 4 spannen die beiden Stössel 15 bei ihrer Drehbewegung um die Drehachse A einen Kegel auf mit einem Kegelwinkel ϕ, der kleiner ist als 90°. Wiederum sind die Zentrumsflächennormalen N der lichten Flächen der Bedienungsöffnungen zu den Stationen 21 - bevorzugterweise eine Sputterstation - und 23 - bevorzugerweise eine Schleusenstation - so ausgerichtet, dass sie mit Erzeugenden bzw. Mantellinien des durch die Stössel 15 bei ihrer Drehbewegung aufgespannten Kegels fluchten. Dasselbe gilt für die erfindungsgemäss vorgesehene, schematisch dargestellte Pumpöffnung 30, woran aus Übersichtsgründen ein Pumpanschluss 31 in Fig. 4 schematisch dargestellt ist.

Auch hier sind in Richtung der Drehachse A betrachtet, bevorzugterweise die Bedienungsöffnungen zu den Stationen 21 bzw. 23 um 180° versetzt angeordnet, während die Pumpöffnung 30 und die ggf. vorgesehene Serviceöffnung (nicht dargestellt) bezüglich der Bedienungsöffnungen wiederum um 90° versetzt angeordnet sind.

Somit wird mit der erfindungsgemässen Anlage einerseits eine äusserst hohe Produktionsrate erzielt, aufgrund der einfachen und nur mit kleinen bewegten Massen konzipierten Anlage, woran die Produktitvität noch hinzukommend dadurch optimiert wird, dass Produktionsstillstandzeiten, wesentlich reduziert werden. Dank der mit ein wesentlicher Teil der vorliegenden Erfindung bildenden Pumpenabschottung werden Stillstandzeiten für Wartung, wie beispielsweise und insbesondere Targetwechsel und/oder Maskenwechsel, auf diejenigen Zeiten minimalisiert, welche für die Wartung tatsächlich notwendig sind. Rekonditionierungszeiten bzw. Zeiten zum Wiederhochfahren der Pumpeinheit entfallen.

## Patentansprüche

1. Beschichtungsanlage für scheibenförmige Werkstücke mit:
- einer Transportkammer (3) mit einer Werkstücktransportanordnung (11), die hat:
- mindestens zwei mit einer gesteuert getriebenen Drehachse (A) verbundene, gesteuert getrieben linear ausfahrbare und rückholbare Transportstössel (15), die in Mantellinien eines Rotationskörpers um die Drehachse (A) liegen und, bezüglich einer Richtung auf der Drehachse, gleichsinnig ausfahrbar bzw. rückholbar sind,
- endständig an jedem Stössel (15) eine Werkstückaufnahme (17),
- mindestens zwei Bedienungsöffnungen (19_{B}, 19_{S}), über welche die Transportkammer (3) mit Stationen (21, 23) kommuniziert, wovon eine (21) eine Beschichtungsstation ist, wobei die Flächennormalen (N) der Bedienungsöffnungen in Richtung von Mantellinien des Rotationskörpers weisen;
- eine mit der Transportkammer (3) über eine Pumpöffnung (30) kommunizierende Pumpeneinheit (34), sowohl für die Transportkammer (3) wie auch für die Beschichtungsstation (21),
**dadurch gekennzeichnet, dass**
mindestens einer der Stössel (15) endständig eine Schliessanordnung aufweist, welche auf die Pumpöffnung ausrichtbar ist und die Schliessanordnung, bei Ausrichtung des Stössels (15) auf die Pumpöffnung (30) und danach dessen Ausfahren (F), mit der Pumpöffnung (30) in dichtend schliessende Wirkverbindung tritt, wobei die Öffnungsflächennormalen (N) der Bedienungsöffnungen (19_{B}, 19_{S}) und der Pumpöffnung (30) parallel zur Ausfahr- resp. Rückholrichtung der Stössel (15) angeordnet sind.

2. Beschichtungsanlage nach Anspruch 1, **dadurch gekennzeichnet, dass** der Rotationskörper ein Zylinder oder Kegel ist und die Stössel parallel oder schief zur Drehachse linear getrieben ausfahrbar und rückholbar sind.

3. Beschichtungsanlage nach Anspruch 1, **dadurch gekennzeichnet, dass** der Rotationskörper ein Kegel mit 90°-Öffnungswinkel ist, die Stössel radial von der Drehachse (A) ausragen und die Bedienungsöffnungen und die Pumpöffnung mit ihren Öffnungsflächennormalen (N) in der Drehebene der Stössel um die Drehachse liegen.

4. Beschichtungsanlage nach einem der Ansprüche 1 bis 3, **dadurch gekennzeichnet, dass** zwei der Stössel (15) vorgesehen sind, welche um 180° bezüglich der Drehachse (A) versetzt angeordnet sind, wobei vorzugsweise auch nur zwei der Stationen (21, 23) vorgesehen sind, wovon die eine eine Schleusenstation (23) ist, und sich die beiden Bedienungsöffnungen (19_{B}, 19_{S}) bezüglich der Drehachse (A) gegenüberliegen.

5. Beschichtungsanlage nach Anspruch 4, **dadurch gekennzeichnet, dass** die Pumpöffnung (30) in der Ebene (E) und bezüglich der Drehachse (A) und den Bedienungsöffnungen (19_{B}, 19_{S}) vorzugsweise um 90° versetzt zwischen letzteren angeordnet ist, wobei weiter bevor-zugt, der Pumpöffnung (30) bezüglich der Drehachse (A) gegenüberliegend, eine Zusatzöffnung (32) in der Wand der Transportkammer (3) angebracht ist.

6. Beschichtungsanlage nach einem der Ansprüche 1 bis 5, **dadurch gekennzeichnet, dass** die Werkstückbeschichtungsstation (21) und die Transportkammer (3) über eine ungesteuerte Kommunikationsverbindung (25) verbunden sind.

7. Beschichtungsanlage nach einem der Ansprüche 1 bis 6, **dadurch gekennzeichnet, dass** die Beschichtungsstation (21) eine Sputterstation ist.

8. Beschichtungsanlage nach einem der Ansprüche 1 bis 7, **dadurch gekennzeichnet, dass** die Werkstückaufnahme durch einen Werkstückaufnahmeteller (17) für mindestens ein scheibenförmiges Werkstück (27) gebildet ist und dieser Teller (17) das Schliessorgan bildet.

9. Beschichtungsanlage nach einem der Ansprüche 1 bis 8, **dadurch gekennzeichnet, dass** die Schliessanordnung an allen Stösseln (15) vorgesehen ist und bevorzugterweise als Werkstückträgerteller ausgebildet ist.

10. Beschichtungsanlage nach Anspruch 9, **dadurch gekennzeichnet, dass** die Schliessanordnung bei Ausrichtung des jeweiligen Stössels (15) auf eine der Bedienungsöffnungen (19) und dessen Ausfahren (F) mit der jeweiligen Öffnung (19) in schliessende Wirkverbindung tritt.

11. Beschichtungsanlage nach einem der Ansprüche 1 bis 10, **dadurch gekennzeichnet, dass** die Schliessanordnung durch ein auf den Stössel (15) aufgebrachtes Werkstück (27) gebildet ist.

12. Verwendung der Beschichtungsanlage nach einem der Ansprüche 1 bis 11 für die Fertigung magnetischer oder optischer Speicherscheiben.

13. Verwendung nach Anspruch 12 für die Fertigung von CD's aller Art.

14. Verfahren zur Herstellung beschichteter scheibenförmiger Substrate, wobei man jeweils
(a) ein Substrat in eine evakuierte Transportkammer einschleust;
(b) das Substrat mittels einer endständig an einem Stössel angeordneten Werkstückaufnahme in der Transportkammer übernimmt und linear in die Transportkammer einholt;
(c) den Stössel mit dem Substrat um einen vorgesehenen Winkel in der Transportkammer dreht;
(d) den Stössel mit dem Substrat in eine Beschichtungsposition linear ausfährt;
(e) das Substrat beschichtet;
(f) den Stössel mit dem Substrat in die Transportkammer linear einholt;
(g) den Stössel und das Substrat in Ausschleusungsposition dreht und linear ausführt;
(h) das Substrat ausschleust;
(i) die Schritte (a) bis (h) mehrere Male durchläuft,
**dadurch gekennzeichnet, dass** danach
(k) eine Pumpöffnung an der Transportkammer mittels einem endständig an einem Stössel angeordneten Schliessanordnung oder dem Substrat dichtend schliesst;
(l) die Transportkammer flutet;
(m) die Transportkammer wieder vakuumdicht schliesst;
(n) die Pumpöffnung wieder freigibt;
(o) die Transportkammer evakuiert;
(p) die Schritte (a) bis (i) wieder aufnimmt.

## Claims

1. Coating plant for disc-like workpieces with:
- a transport chamber (3) with a workpiece transport arrangement (11) which has:
- at least two transport rams (15) which are connected with a controlledly driven rotary axis (A), can be extended or retracted linear under controlled drive, lie in the surface line of a rotation body about the rotary axis (A) and can be extended and retracted in the same direction in relation to a direction on the rotary axis,
- a workpiece holder (17) at the end of each ram (15),
- at least two service openings (19_{B}, 19_{S}) via which the transport chamber (3) communicates with stations (21, 23), one of which (21) is a coating station, the surface normals (N) of the service openings pointing in the direction of surface lines of the rotation body;
- a pump unit (34) communicating with the transport chamber (3) via a pump opening (30) both for the transport chamber (3) and for the coating station (21),
**characterised in that**
at least one of the rams (15) has at its end a closing arrangement which can be aligned to the pump opening, and on alignment of the ram (15) to the pump opening (30) and its subsequent extension (F), the closing arrangement enters a tightly sealed active connection with the pump opening (30), the opening surface normals (N) of the service openings (19_{B}, 19_{S}) and the pump opening (30) being arranged parallel to the extension and retraction direction respectively of the rams (15).

2. Coating plant according to claim 1, **characterised in that** the rotation body is a cylinder or a cone and the rams can be extended and retracted under linear drive parallel or oblique to the rotary axis.

3. Coating plant according to claim 1, **characterised in that** the rotation body is a cone with a 90° opening angle, the rams protrude radially from the rotary axis (A) and the service openings and the pump opening with their opening surface normals (N) lie in the rotation plane of the rams about the rotation axis.

4. Coating plant according to any of claims 1 to 3, **characterised in that** two rams (15) are provided which are arranged offset by 180° in relation to the rotary axis (A), where preferably only two stations (21, 23) are provided of which one is a lock station (23), and the two service openings (19_{B}, 19_{S}) lie opposite each other in relation to the rotary axis (A).

5. Coating plant according to claim 4, **characterised in that** the pump opening (30) is arranged in the plane (E) and in relation to the rotary axis (A) and the service openings (19_{B}, 19_{S}) is arranged preferably offset by 90° between the latter, where further preferably an additional opening (32) is made in the wall of the transport chamber (3) opposite the pump opening (30) in relation to the rotary axis (A).

6. Coating plant according to any of claims 1 to 5, **characterised in that** the workpiece coating station (21) and the transport chamber (3) are connected via an uncontrolled communication connection (25).

7. Coating plant according to any of claims 1 to 6, **characterised in that** the coating station (21) is a sputter station.

8. Coating plant according to any of claims 1 to 7, **characterised in that** the workpiece holder is formed by a workpiece holder plate (17) for at least one disc-like workpiece (27) and this plate (17) forms the closing element.

9. Coating plant according to any of claims 1 to 8, **characterised in that** the closing arrangement is provided on all rams (15) and is preferably formed as a workpiece carrier plate.

10. Coating plant according to claim 9, **characterised in that** on alignment of the respective ram (15) to one of the service openings (19) and its extension (F), the closing arrangement enters a closing active connection with the respective opening (19).

11. Coating plant according to any of claims 1 to 10, **characterised in that** the closing arrangement is formed by a workpiece (27) attached to the ram (15).

12. Use of the coating plant according to any of claims 1 to 11 for the production of magnetic or optical storage discs.

13. Use according to claim 12 for the production of CDs of all types.

14. Process for the production of coated disc-like substrates, wherein
(a) a substrate is introduced via a lock into an evacuated transport chamber;
(b) the substrate is carried by means of a workpiece holder arranged on the end of a ram into the transport chamber and brought linear into the transport chamber;
(c) the ram with the substrate is rotated about a specified angle in the transport chamber;
(d) the ram with the substrate is extended linear into a coating position;
(e) the substrate is coated;
(f) the ram with the substrate is brought linear into the transport chamber;
(g) the ram and the substrate are rotated into the lock ejection position and extended linear;
(h) the substrate is ejected from the lock;
(i) steps (a) to (h) are repeated several times,
**characterised in that** thereafter
(k) a pump opening on the transport chamber is tightly closed by means of a closing arrangement or the substrate arranged at the end of the ram;
(l) the transport chamber is flooded;
(m) the transport chamber is again closed vacuum-tight;
(n) the pump opening is released again;
(o) the transport chamber is evacuated;
(p) steps (a) to (i) are repeated.

## Revendications

1. Installation d'application de revêtement pour des pièces en forme de plaques, comportant :
- une chambre de transport (3) avec un dispositif de transport de pièces (11) qui comprend :
- au moins deux poussoirs de transport (15) qui sont reliés à un axe de rotation (A) entraîné de manière commandée, qui sont aptes à être déployés et rétractés linéairement de manière commandée, qui sont situés sur les lignes génératrices d'un corps de révolution autour de l'axe de rotation (A) et qui sont aptes à être déployés et rétractés dans le même sens, par rapport à une direction sur l'axe de rotation,
- à l'extrémité de chaque poussoir (15) un porte-pièce (17),
- au moins deux ouvertures de desserte (19_{B}, 19_{S}) grâce auxquelles la chambre de transport (3) communique avec des stations (21, 23) dont une (21) est une station d'application de revêtement, les normales superficielles (N) des ouvertures de desserte étant dirigées dans le sens des génératrices du corps de révolution ;
- une unité de pompage (34) qui communique avec la chambre de transport (3) grâce à une ouverture de pompage (30), aussi bien pour la chambre de transport (3) que pour la station d'application de revêtement (21) ;
**caractérisée en ce que** l'un au moins des poussoirs (15) comporte à une extrémité un dispositif de fermeture qui est apte à être aligné sur l'ouverture de pompage et qui, quand le poussoir (15) est aligné sur l'ouverture de pompage (30) puis est déployé (F), vient en relation fonctionnelle avec l'ouverture de pompage (30) en vue d'une fermeture étanche, les normales superficielles (N) des ouvertures de desserte (19_{B}, 19_{S}) et de l'ouverture de pompage (30) étant parallèles au sens de déploiement et de rétraction des poussoirs (15).

2. Installation d'application de revêtement selon la revendication 1, **caractérisée en ce que** le corps de révolution est un cylindre ou un cône et les poussoirs sont aptes à être déployés et rétractés, avec une commande linéaire, parallèlement ou en biais par rapport à l'axe de rotation.

3. Installation d'application de revêtement selon la revendication 1, **caractérisée en ce que** le corps de révolution est un cône avec un angle d'ouverture de 90°, les poussoirs dépassent radialement de l'axe de rotation (A) et les ouvertures de desserte et l'ouverture de pompage sont situées avec leurs normales superficielles d'ouvertures (N) dans le plan de rotation des poussoirs autour de l'axe de rotation.

4. Installation d'application de revêtement selon l'une des revendications 1 à 3, **caractérisée en ce qu'**il est prévu deux des poussoirs (15), qui sont décalés de 180° par rapport à l'axe de rotation (A), étant précisé qu'il est prévu de préférence seulement deux des stations (21, 23), l'une étant une station sas (23) et les deux ouvertures de desserte (19_{B}, 19_{S}) étant disposées à l'opposé l'une de l'autre par rapport à l'axe de rotation (A).

5. Installation d'application de revêtement selon la revendication 4, **caractérisée en ce que** l'ouverture de pompage (30) est disposée dans le plan (E) et est disposée entre les deux ouvertures de desserte (19_{B}, 19_{S}) en étant décalée de préférence de 90° par rapport à celles-ci et à l'axe de rotation (A), étant précisé aussi qu'il est prévu de préférence, à l'opposé de l'ouverture de pompage (30) par rapport à l'axe de rotation (A), une ouverture supplémentaire (32) dans la paroi de la chambre de transport (3).

6. Installation d'application de revêtement selon l'une des revendications 1 à 5, **caractérisée en ce que** la station d'application de revêtement (21) et la chambre de transport (3) sont reliées par une liaison de communication (25) non commandée.

7. Installation d'application de revêtement selon l'une des revendications 1 à 6, **caractérisée en ce que** la station d'application de revêtement (21) est une station de pulvérisation cathodique.

8. Installation d'application de revêtement selon l'une des revendications 1 à 7, **caractérisée en ce que** le porte-pièce est formé par un plateau porte-pièce (17) pour au moins une pièce en forme de plaque (27), et ce plateau (17) forme l'organe de fermeture.

9. Installation d'application de revêtement selon l'une des revendications 1 à 8, **caractérisée en ce que** le dispositif de fermeture est prévu sur tous les poussoirs (15) et est conçu de préférence comme un plateau porte-pièce.

10. Installation d'application de revêtement selon la revendication 9, **caractérisée en ce que** le dispositif de fermeture, quand un poussoir (15) est aligné sur l'une des ouvertures de desserte (19) et quand ledit poussoir (15) est déployé (F), vient en relation fonctionnelle de fermeture avec l'ouverture correspondante (19).

11. Installation d'application de revêtement selon l'une des revendications 1 à 10, **caractérisée en ce que** le dispositif de fermeture est formé par une pièce (27) posée sur le poussoir (15).

12. Utilisation de l'installation d'application de revêtement selon l'une des revendications 1 à 11 pour fabriquer des disques de mémoire magnétiques ou optiques.

13. Utilisation selon la revendication 12 pour fabriquer des CD de toutes sortes.

14. Procédé pour fabriquer des substrats revêtus en forme de plaques, selon lequel
(a) on introduit un substrat dans une chambre de transport sous vide ;
(b) on prend le substrat dans la chambre de transport à l'aide d'un porte-pièce disposé à l'extrémité d'un poussoir, et on le rentre linéairement dans la chambre de transport ;
(c) on tourne le poussoir avec le substrat suivant un angle prévu, dans la chambre de transport ;
(d) on déploie le poussoir avec le substrat linéairement jusqu'à une position d'application de revêtement ;
(e) on applique un revêtement sur le substrat ;
(f) on rentre le poussoir avec le substrat linéairement dans la chambre de transport ;
(g) on tourne le poussoir et le substrat dans une position de sortie et on les sort linéairement ;
(h) on sort le substrat ;
(i) on réalise les étapes (a) à (h) plusieurs fois,
**caractérisé en ce qu'**ensuite,
(k) on ferme de manière étanche une ouverture de pompage sur la chambre de transport à l'aide d'un dispositif de fermeture disposé à l'extrémité d'un poussoir, ou à l'aide du substrat ;
(l) on inonde la chambre à vide ;
(m) on referme la chambre de transport de manière étanche au vide ;
(n) on dégage à nouveau l'ouverture de pompage ;
(o) on évacue la chambre de transport ;
(p) on reprend les étapes (a) à (i).
